Europäisches Patentamt

European Patent Office

Office européen des brevets

(19)

(11) Veröffentlichungsnummer: **0 309 767 B1**

(12) # EUROPÄISCHE PATENTSCHRIFT

(45) Veröffentlichungstag der Patentschrift: 06.11.91

(51) Int. Cl.5: **H01J 37/07**

(21) Anmeldenummer: 88114377.0

(22) Anmeldetag: 02.09.88

(54) **Strahlerzeugendes System für Elektronenstrahlmessgeräte.**

(30) Priorität: 28.09.87 DE 3732620

(43) Veröffentlichungstag der Anmeldung:
05.04.89 Patentblatt 89/14

(45) Bekanntmachung des Hinweises auf die
Patenterteilung:
06.11.91 Patentblatt 91/45

(84) Benannte Vertragsstaaten:
**DE FR GB NL**

(56) Entgegenhaltungen:
**DE-C- 3 150 848**
**FR-A- 2 395 599**

(73) Patentinhaber: **SIEMENS AKTIENGESELL-
SCHAFT**
**Wittelsbacherplatz 2**
**W-8000 München 2(DE)**

(72) Erfinder: **Lischke, Burkhard, Prof. Dr.**
**In der Heuluss 13**
**W-8000 München 82(DE)**
Erfinder: **Winkler, Dieter, Dipl.-Ing.**
**Staudingerstrasse 57**
**W-8000 München 83(DE)**

## Beschreibung

Die Erfindung betrifft ein strahlerzeugendes System für Elektronenstrahlmeßgeräte nach dem Oberbegriff des Patentanspruchs 1.

Ein solches System ist beispielsweise aus J. Vac. Sci. Technol. 15 (4), 1978, Seite 1554 bis 1560 (siehe insbesondere Seite 1558, Figur 7) und DE-A-31 50 848 bekannt. Die Lebensdauer der in diesen Elektronenstrahlerzeugern verwendeten $LaB_6$-Kathoden wird durch deren thermisch ungünstige Halterung begrenzt. Aufgrund des durch die Heizelemente erzeugten Temperaturgradienten im Kristallschaft verdampft das Kathodenmaterial im Bereich der Halterung sehr viel schneller als an der elektronenemittierenden Spitze. Dies wirkt sich nachteilig auf die mechanische Stabilität der Kathode aus und führt langfristig zu deren Zerstörung (s. beispielsweise Scanning Electron Microscopy, 1985/4, Seiten 1327 bis 1338, insbesondere Seite 1331, Figur 6a).

Die FR-A-2 395 599 beschreibt einen Elektronenstrahlerzeuger, dessen scheibenförmige $LaB_6$-Kathode mit Hilfe einer schnell lösbaren Halterung zentriert bezüglich der durch die Steuerelektrode und die Anode definierten Strahlachse angeordnet ist. Die Halterung besteht aus einem hohlzylinderförmigen oberen Teil, einem die Kathode randseitig umfassenden unteren Teil und zwei die Haltekräfte erzeugenden Metallringen. Der einen der Metallringe aufnehmende untere Halterungsteil ist hierbei mit einer Bohrung versehen, die die Elektronenemission auf einen kreisförmigen Bereich auf der der Steuerelektrode bzw. Anode zugewandten Kathodenoberfläche begrenzt.

Der Erfindung liegt die Aufgabe zugrunde, ein strahlerzeugendes System der eingangs genannten Art anzugeben, dessen Kathodenhalterung eine thermisch günstige Befestigung der Kathode gewährleistet. Diese Aufgabe wird erfindungsgemäß durch ein strahlerzeugendes System mit den in Patentanspruch 1 angegebenen Merkmalen gelöst.

Der mit der Erfindung erzielbare Vorteil besteht insbesondere darin, daß sich die Lebensdauer einer in erfindungsgemäßer Weise gehaltenen Boridkathode deutlich verlängert. Außerdem ist eine wesentlich geringere Heizleistung erforderlich, um die Kathode auf die gewünschte Betriebstemperatur zu bringen.

Die Ansprüche 2 bis 4 betreffen bevorzugte Ausgestaltungen und Weiterbildungen der im folgenden anhand der Zeichnung erläuterten Erfindung. Hierbei zeigt

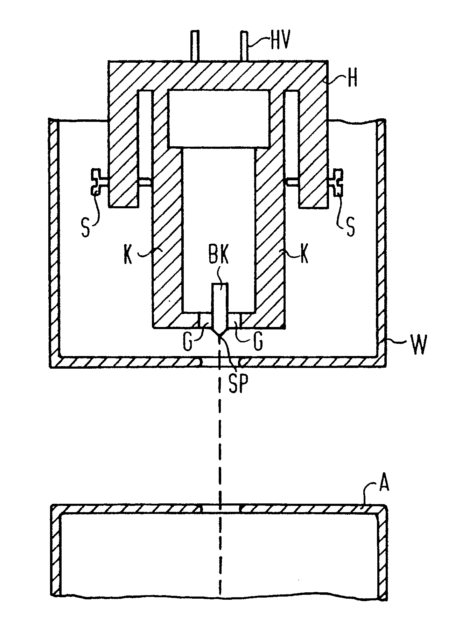

Fig. 1 den schematischen Aufbau eines erfindungsgemäßen strahlerzeugenden Systems.

Der in der FIG schematisch dargestellte Strahlerzeuger für Elektronenstrahlmeßgeräte, insbesondere Rasterelektronenmikroskope und Elektronenstrahltester, besteht im wesentlichen aus einer üblicherweise auf Erdpotential liegenden Anode A, einer Steuerelektrode W (Wehnelt-Elektrode) und einer direkt geheizten Boridkathode BK, die mit Hilfe einer Halterung H zentriert in der Öffnung der gegenüber der Kathode BK negativ vorgespannten Steuerelektrode W angeordnet ist. Die Halterung H umfaßt zwei Stellschrauben S und eine aus zwei metallischen Klemmen K bestehende Einspannvorrichtung, die die mit Hilfe der Stellschrauben S erzeugten Haltekräfte auf die beiden unmittelbar unterhalb der Spitze SP des $LaB_6$-Kristalls angeordneten Graphitwürfel G übertragen. Aufgrund dieser thermisch und mechanisch günstigen Halterung ist nur eine geringe Heizleistung von beispielsweise 10 Watt notwendig, um die im Hochvakuum $133.10^{-6}$ bis $133.10^{-7}$ Pa ($10^{-6}$ bis $10^{-7}$ Torr) angeordnete Broidkathode BK auf die erforderliche Betriebstemperatur von etwa 1200 bis 1800 ˚C zu bringen. Die Heizspannung wird hierbei über die auf dem Kathodenpotential von etwa - 3 kV bis - 30 kV liegenden Anschlußklemmen HV in das System eingespeist.

Durch die erfindungsgemäße Halterung der Kathode BK ist gewährleistet, daß der $LaB_6$-Kristall in der Einspannebene nur unwesentlich heißer ist als an der elektronenemittierenden Spitze. Hieraus resultiert eine im Vergleich zu bekannten Kathodenhalterungen (hohe Temperaturdifferenz zwischen Kristallspitze und Kristallschaft im Bereich der elektrischen Kontakte) erheblich niedrigere Abdampfrate, insbesondere an den den Graphitwürfeln G gegenüberliegenden Kristallflächen. Der elektrische Kontakt bleibt deshalb auch bei einer längeren Betriebsdauer der Kathode BK erhalten. Außerdem wird deren mechanische Stabilität nicht durch die in bekannten Systemen beobachtete Reduktion des Kristallquerschnitts oberhalb der Einspannebene beeinträchtigt.

## Patentansprüche

1. Strahlerzeugendes System für Elektronenstrahlmeßgeräte mit
   - einer direkt geheizten Boridkathode (BK),
   - einer in Elektronenstrahlrichtung hinter der Boridkathode (BK) angeordneten elektronenbeschleunigenden Elektrode (A),
   - einer zwischen der Boridkathode (BK) und der elektronenbeschleunigenden Elektrode (A) angeordneten Steuerelektrode (W)
   - und mit einer eine Einspannvorrichtung (K, S) und ein Halterungsteil (G) aufweisenden Kathodenhalterung (H), wobei das Halterungsteil (G) die von der Einspannvorrichtung (K, S) erzeugten Haltekräfte auf die Boridkathode (BK) überträgt,

**dadurch gekennzeichnet,**

daß das Halterungsteil (G) unmittelbar unterhalb der elektronenemittierenden Spitze (SP) der Boridkathode (BK) angeordnet ist, so daß die Boridkathode (BK) während des Betriebes im Bereich des Halterungsteils (G) nur unwesentlich heißer ist als an der Spitze (SP).

2. Strahlerzeugendes System nach Anspruch 1, **gekennzeichnet** durch eine Lanthan-Hexaboridkathode.

3. Elektronenstrahlerzeugendes System nach Anspruch 1 oder 2, dadurch **gekennzeichnet,** daß das Halterungsteil (G) aus Graphit besteht.

4. Strahlerzeugendes System nach Anspruch 3, dadurch **gekennzeichnet,** daß das Halterungsteil (G) aus zwei Graphitwürfeln besteht.

**Claims**

1. Beam generating system for electron beam measuring instruments having
   - a directly heated boride cathode (BK),
   - an electron-accelerating electrode (A) arranged behind the boride cathode (BK), in the direction of the electron beam,
   - a control electrode (W) arranged between the boride cathode (BK) and the electron-accelerating electrode (A),
   - and having a cathode mount (H) that has a clamping mechanism (K, S) and a holding part (G), the holding part (G) transmitting to the boride cathode (BK) the retaining forces generated by the clamping mechanism (K, S),

   characterised in that the holding part (G) is arranged immediately under the electron-emitting tip (SP) of the boride cathode (BK), so that during operation the boride cathode (BK) is only insignificantly hotter in the region of the holding part (G) than at the tip (SP).

2. Beam generating system according to Claim 1, characterised by a lanthan-hexaboride cathode.

3. Electron beam generating system according to Claim 1 or 2, characterised in that the holding part (G) consists of graphite.

4. Beam generating system according to Claim 3, characterised in that the holding part (G) consists of two graphite cubes.

**Revendications**

1. Système produisant un faisceau pour des appareils de mesure à faisceau d'électrons, comportant
   - une cathode (BK) formée d'un borure, chauffée directement,
   - une électrode (A) accélérant les électrons et disposée dans la direction du faisceau d'électrons en arrière de la cathode (BK) formée d'un borure,
   - une électrode de commande (W) disposée entre la cathode (BK) formée d'un borure et l'électrode (A) accélérant les électrons, et
   - un dispositif (H) de support de cathode, qui comporte un dispositif de serrage (K,S) et une partie de retenue (G), cette dernière transmettant les forces de retenue, produites par le dispositif de serrage (K,S), à la cathode (BK) formée d'un borure,

   caractérisé par le fait que la partie de retenue (G) est disposée directement au-dessous de la pointe (SP), qui émet les électrons, de la cathode (BK) formée d'un borure de sorte que cette dernière est seulement légèrement plus chaude que la pointe (SP) pendant le fonctionnement dans la zone de la partie de retenue (G).

2. Système produisant un faisceau d'électrons suivant la revendication 1, caractérisé par une cathode formée d'hexaborure de lanthane.

3. Système produisant un faisceau d'électrons suivant la revendication 1 ou 2, caractérisé par le fait que la partie de retenue (G) est réalisée en graphite.

4. Système produisant un faisceau suivant la revendication 3, caractérisé par le fait que la partie de retenue (G) est constituée par deux cubes en graphite.